# EUROPEAN PATENT APPLICATION

(11) **EP 2 023 387 A1**
(43) Date of publication of application: **11.02.2009**
(21) Application number: 07737921.2
(22) Date of filing: 07.03.2007
(51) Int. Cl.: H01L 23/34, H01L 23/12

(54) **SEMICONDUCTOR DEVICE, ELECTRONIC PARTS MODULE, AND METHOD FOR MANUFACTURING THE SEMICONDUCTOR DEVICE**

(30) Priority: 26.05.2006 JP 2006146120
(71) Applicant: Murata Manufacturing Co. Ltd., Nagaokakyo-shi, Kyoto-fu 617-8555 (JP)
(72) Inventor: NAKAGOSHI, Hideo, Nagaokakyo-shi Kyoto 617-8555 (JP)
(74) Representative: Schoppe, Fritz
(86) International application number: PCT/JP2007/054407
(87) International publication number: WO 2007/138771

(57) **Abstract**

Provided is a semiconductor device including a semiconductor element, the semiconductor device having satisfactory heat dissipation characteristics and being capable of being easily manufactured.

A semiconductor element (12) is provided with a heat dissipating path (18) defined by a non-through hole (16) opened to a first principal surface (13) and formed by filling the non-through hole (16) with a conductive material (17). The semiconductor element (12) is bonded to a heat sink (14) with the conductive material (17) disposed therebetween. Solder can be used as one preferable example of the conductive material (17). By introducing molten solder being molten into the non-through hole (16) while having solder disposed between the semiconductor element (12) and the heat sink (14), the heat dissipating path (18) is formed and the state in which the heat sink (14) is bonded to the semiconductor element (12) is obtained.

## Description

### Technical Field

The present invention relates to a semiconductor device, an electronic component module including a semiconductor device, and a method for manufacturing a semiconductor device. In particular, the present invention relates to an improvement in heat dissipation characteristics of a semiconductor element included in a semiconductor device.

### Background Art

For a semiconductor device including a semiconductor element, when heat is produced in the semiconductor element during its operation, it is important to efficiently dissipate the heat in order to prevent the semiconductor element from being degraded or destroyed and ensure reliability of the semiconductor element. Accordingly, various techniques for improving the heat dissipation characteristics of a semiconductor element are being developed.

A semiconductor device including heat dissipating means interesting to the present invention is described in, for example, Japanese Unexamined Patent Application Publication No. 2001-284503 (Patent Document 1). The patent document 1 describes a configuration in which heat dissipating means is provided in relation to a semiconductor element mounted on a principal surface of a wiring board with conductor bumps disposed therebetween. The heat dissipating means includes a flat-shaped portion and a projection disposed in a central part of the flat-shaped portion. The semiconductor element includes a through hole formed in a direction substantially perpendicular to the principal surface. The heat dissipating means is disposed such that its projection is inserted in the through hole and the flat-shaped portion is arranged along the principal surface of the semiconductor element, and the heat dissipating means acts so as to dissipate heat of the semiconductor element.

As described above, the configuration described in the patent document 1 captures attention in that favorable heat dissipation characteristics are obtained by disposing a part of the heat dissipating means, i.e., the projection inside the semiconductor element having heat generation in itself. Unfortunately, the configuration described in the patent document 1 has the following problems.

First, the semiconductor element has the through hole for allowing the projection of the heat dissipating means to be inserted therein. This through hole portion is considered to be a wasted space in terms of arrangement of circuit elements because that through hole portion cannot be used as a space for arranging circuit elements to be placed in the semiconductor element. This makes it difficult to miniaturize the semiconductor element, and correspondingly, makes it difficult to miniaturize the semiconductor device including the semiconductor element and thus the electronic component module including the semiconductor device.

In addition, manufacturing the heat dissipating means having the projection is relatively complicated and requires relatively high cost. In this case, if the size of the projection is reduced to further reduce the size of the above-described wasted space in the semiconductor element, high-precision micromachining is necessary, and this further increases the cost of manufacturing. On the other hand, if the size of the projection is increased to suppress an increase in the cost of manufacturing, the above-mentioned wasted space is further increased.

It is necessary to insert the projection formed in the heat dissipating means into the through hole of the semiconductor element in mounting the heat dissipating means on the semiconductor device. Unfortunately, aligning the projection and the through hole in the insertion is relatively complicated, so this makes it difficult to improve productivity. In particular, when the heat dissipating means has a plurality of projections, because it is necessary to insert the plurality of projections into a plurality of through holes formed in the semiconductor element at a time, it makes further difficult to align them, and this results in further degradation in productivity. Patent Document 1: Japanese Unexamined Patent Application Publication No. 2001-284503

### Disclosure of Invention

### Problems to be Solved by the Invention

It is an object of the present invention to provide a semiconductor device capable of solving the above problems, an electronic component module including the semiconductor device, and a method for manufacturing the semiconductor device.

### Means for Solving the Problems

A semiconductor device according to the present invention includes a semiconductor element and a metallic heat sink arranged along a first principal surface of the semiconductor element. To solve the above-described technical problems, the semiconductor element is provided with a heat dissipating path, the heat dissipating path being defined by a non-through hole opened to the first principal surface and formed by filling the non-through hole with a conductive material, and the heat sink is bonded to the semiconductor element with the conductive material disposed therebetween.

The conductive material may preferably include solder.

In the semiconductor device according to the present invention, when a conductive film is disposed on a second principal surface of the semiconductor element, the second principal surface being opposite to the first principal surface, a bottom of the non-through hole may preferably be defined by the conductive film.

The present invention is also directed to an electronic component module including the semiconductor device described above and also including a wiring board having a cavity. In the electronic component module according to the present invention, the semiconductor device is received in the cavity such that the heat sink faces outward.

Furthermore, the present invention is also directed to a method for manufacturing a semiconductor device. The method for manufacturing a semiconductor device according to the present invention has the following configuration.

That is, a semiconductor element including a non-through hole opened to a first principal surface is prepared, and solder for use as a conductive material to be filled in the non-through hole to form a heat dissipating path is prepared. Further, a metallic heat sink to be arranged along the first principal surface of the semiconductor element is prepared.

The heat sink is arranged along the first principal surface of the semiconductor element, the solder being molten is introduced into the non-through hole while the solder is disposed between the first principal surface of the semiconductor element and the heat sink, the heat dissipating path in which the non-through hole is filled with the solder is thus formed, and a state in which the heat sink is bonded to the semiconductor element with the solder disposed therebetween is established.

In the method for manufacturing a semiconductor device, before introducing the solder being molten into the non-through hole, as described above, forming a metallic film on an inner surface of the non-through hole and on the first principal surface may preferably be carried out.

### Advantages

In accordance with the present invention, because the hole defining the heat dissipating path does not penetrate, even when a fluid material, such as molten solder, conductive paste, or conductive adhesive, is used as a conductive material for use in being filled in the hole, the conductive material does not flow out and can be retained within the hole. Accordingly, a fluid material, such as the above molten solder, can be used without problems.

In accordance with a method for manufacturing a semiconductor device according to the present invention, as described above, a fluid material can be used as the conductive material, it can be introduced into the non-through hole utilizing fluidity of the molten solder, and the heat dissipating path is thus formed by filling the non-through hole with the solder and the state in which the heat sink is bonded to the semiconductor element with the solder disposed therebetween is obtained. Accordingly, unlike in the above-described technique described in the patent document 1, a complicated process of forming a projection in a heat dissipating member in advance and then inserting the projection into a though hole of a semiconductor element is unnecessary. Therefore, the semiconductor device can be manufactured with high productivity. Because there is no need to form a projection in a heat sink in advance and a simple flat shape can be used as the heat sink, the heat sink can be manufactured with a lower cost than that of the heat dissipating member described in the patent document 1.

In the method for manufacturing the semiconductor device described above, when the molten solder is introduced into the non-through hole after the metallic film is formed on the inner surface of the non-through hole and on the first principal surface of the semiconductor element, a wet-up phenomenon of the metallic film acts, in addition to the capillary action caused by the non-through hole. Accordingly, the solder can be introduced into the hole quickly with high filling capabilities.

In accordance with the present invention, as long as a circuit arrangement in the semiconductor element is not affected, any number of heat dissipating paths can be provided in any place within the semiconductor element. As a result, when a heat dissipating path is disposed in the vicinity of a heating portion within the semiconductor element, higher heat dissipation effects are obtainable. When a heat dissipating path is disposed in a place where the circuit arrangement in the semiconductor element is originally unnecessary, an increase in the size of the semiconductor element caused by the provision of the heat dissipating path can be avoided.

In accordance with the present invention, the heat sink is bonded to the semiconductor element with the conductive material that is disposed therebetween and that forms the heat dissipating path provided to the semiconductor element, and in this state, the heat dissipating path exercises anchoring effects. Accordingly, the strength of bonding the heat sink to the semiconductor element can be enhanced.

When solder is used as the conductive material in the semiconductor device according to the present invention, high thermal conductivity is obtainable, and heat dissipation characteristics can be enhanced. The use of solder containing no resin component and having a high melting point does not cause a bonding state to change over time even when the semiconductor element generates heat, so the highly reliable bonding state between the semiconductor element and the heat sink is obtainable.

When the conductive film is disposed on the second principal surface of the semiconductor element and the bottom of the non-through hole is defined by this conductive film in the semiconductor device according to the present invention, the conductive film, the heat dissipating path, and the heat sink can be used as a grounding path. This can reduce impedance and improve characteristics of the semiconductor device and the electronic component module including the semiconductor device, and facilitate supporting for higher frequencies.

### Brief Description of Drawings

[Fig. 1] Fig. 1 is a cross-sectional view that illustrates an electronic component module 2 including a semiconductor device 1 according to one embodiment of the present invention.
[Fig. 2] Fig. 2 is an enlarged cross-sectional view that illustrates a portion A shown in Fig. 1.
[Fig. 3] Fig. 3 is an illustration that describes a method for manufacturing the electronic component module 2 described with reference to Figs. 1 and 2 and that corresponds to Fig. 2.
[Fig. 4] Fig. 4 is an illustration that describes another method for manufacturing the electronic component module 2 described with reference to Figs. 1 and 2 and that corresponds to Fig. 2 or 3.

### Reference Numerals

- 1: semiconductor device
- 2: electronic component module
- 3: wiring board
- 11: cavity
- 12: semiconductor element
- 13: first principal surface
- 14: heat sink
- 15: opening
- 16: non-through hole
- 17: conductive material
- 18: heat dissipating path
- 19: second principal surface
- 21: conductive bump
- 23: metallic film

### Best Mode for Carrying Out the Invention

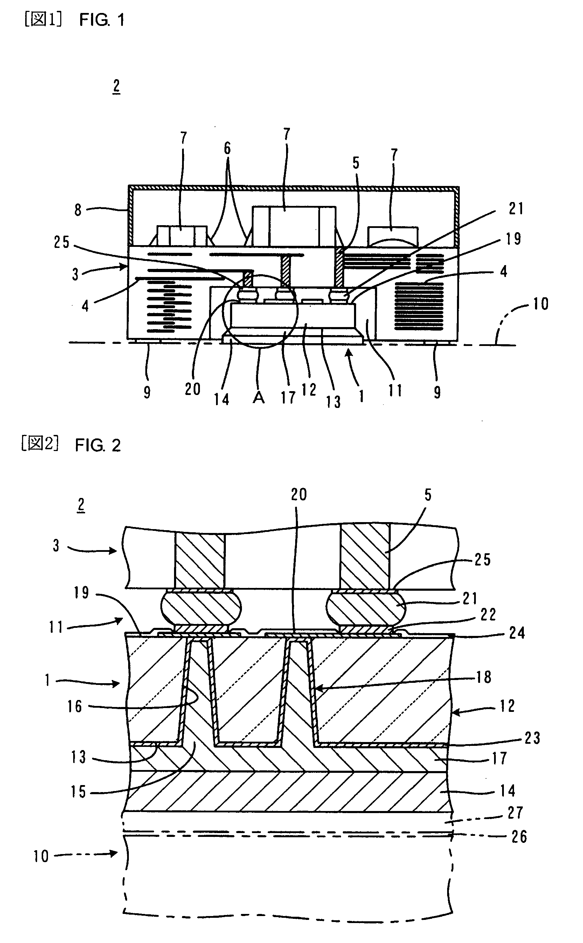

Fig. 1 is a cross-sectional view that illustrates an electronic component module 2 including a semiconductor device 1 according to one embodiment of the present invention. Fig. 2 is an enlarged cross-sectional view that illustrates a portion A shown in Fig. 1.

The electronic component module 2 includes a wiring board 3. The wiring board 3 has a multilayer structure in which a plurality of ceramic layers or organic material layers are laminated. The wiring board 3 has one or more internal conductive films 4 and one or more via-hole conductors 5 formed therein. A wiring conductor including these internal conductive films 4 and via-hole conductors 5 forms a passive element, for example, an inductor, a capacitor, and a resistor.

One or more external conductive films (not shown) are formed on the upper surface of the wiring board 3 as needed. One or more surface-mountable components 7 are mounted while being connected to these external conductive films with solder 6 disposed therebetween. Additionally, a metallic cover 8 is attached to the wiring board 3 so as to cover these surface-mountable components 7. One or more external conductive films 9 are formed on the lower surface of the wiring board 3. These external conductive films 9 function as a terminal electrode used when the electronic component module 2 is mounted on a mother board 10, which is indicated by phantom lines.

A cavity 11 is formed in the lower surface of the wiring board 3. The semiconductor device 1 is received in the cavity 11. The semiconductor device 1 includes a semiconductor element 12 and a heat sink 14 arranged along a first principal surface 13 of the semiconductor element 12. The semiconductor device 1 is received in the cavity 11 such that the heat sink 14 faces outward. The heat sink 14 has a simple flat shape and can be made of a metal that has relatively high thermal conductivity, for example, a Ni-Co-Fe alloy, Ni-Fe alloy, Ni-Cr-Fe alloy, Cr-Fe alloy, Cr-Ni alloy, copper, or aluminum. It is preferable that the heat sink 14 be as thin as possible in its processable range to obtain satisfactory heat dissipation characteristics.

Because Fig. 1 does not illustrate a detailed cross section of the semiconductor element 12, the structure of the electronic component module 2 is described in further detail mainly with reference to Fig. 2. The semiconductor element 12 is provided with one or more heat dissipating paths 18 defined by one or more non-through holes 16 positioning one or more openings 15 opened to the first principal surface 13 and formed by filling the non-through holes 16 with a conductive material 17. The above-described heat sink 14 is bonded to the semiconductor element 12 with the conductive material 17 disposed therebetween.

The above-described conductive material 17 can be composed of solder, conductive paste or conductive adhesive, for example. Particularly preferably, the conductive material 17 may be composed of solder. As will be clear from the description about a manufacturing method described below, the conductive material 17 may be composed of different materials; one for a portion inside the non-through holes 16 and the other for a portion outside the non-through holes 16.

One or more conductive films 20 are formed on a second principal surface 19 of the semiconductor element 12, the second principal surface 19 being opposite to the first principal surface 13. In the present embodiment, defining the bottom of each of the non-through holes 16 by a corresponding conductive film 20 enables the non-through hole 16 to have a non-through state.

One or more conductive bumps 21 are disposed on the second principal surface of the semiconductor element 12. More specifically, under-bump metal 22 is formed on the above-described conductive films 20, and the conductive bumps 21 are formed thereon.

Examples of the material of each of the conductive bumps 21 include gold or conductive resin. One particularly preferable example may be solder. When the conductive bump 21 is composed of solder, the under-bump metal 22 can be composed of, for example, a titanium film formed on each of the conductive films 20 and a nickel film formed thereon.

One example used as the solder forming the conductive bump 21 is Sn3.5Ag solder (melting at 221°C). One example used as the solder forming the conductive material 17 is Au20Sn solder (melting at 280°C).

A metallic film 23 is formed on the inner surface of each of the non-through holes 16 and on the first principal surface 13 of the semiconductor element 12. The above-described conductive material 17 are applied so as to be in contact with the metallic film 23. A protective film 24 is formed so as to cover the second principal surface 19 of the semiconductor element 12.

Although not shown in Figs. 1 and 2, underfill resin is injected between the semiconductor element 12 and the internal surface of the cavity 11.

As previously described, the semiconductor device 1 including the semiconductor element 12 and the heat sink 14 is received in the cavity 11 of the wiring board 3, and the semiconductor device 1 is melt-bonded to a conductive film 25 formed on the bottom of the cavity 11 with the conductive bump 21 disposed therebetween. The conductive film 25 can be electrically connected to the via-hole conductor 5.

The electronic component module 2 having the above structure is mounted on the mother board 10, as previously described. As indicated by the phantom lines in Fig. 2, the mother board 10 includes a conductive film 26. When the electronic component module 2 is implemented on the mother board 10, the heat sink 14 is bonded to the conductive film 26 with solder 27 disposed therebetween over the entire surface thereof. Examples of the solder 27 include Sn3Ag0.5Cu (melting at 219°C) and Sn0.7Cu (melting at 227°C).

Heat generated in the semiconductor element 12 is conveyed to the heat sink 14 through the heat dissipating paths 18 and is dissipated to the mother board 10 through the solder 27 and the conductive film 26. At this time, arranging the heat dissipating paths 18 in the vicinity of the heating portion inside the semiconductor element 12 can offer higher dissipating effects.

Because each of the heat dissipating paths 18 also has the conductive capabilities, circuitry formed from the conductive films 20 on the second principal surface 19 of the semiconductor element 12 can be grounded through the heat dissipating path 18 and the heat sink 14 using a short distance. Accordingly, the impedance of the grounding path can be reduced. As a result, the characteristics of the semiconductor device 1 and the electronic component module 2 can be improved, and this can facilitate supporting for higher frequencies.

The heat dissipating path 18 can be disposed at a position where it is originally unnecessary to arrange circuits in the semiconductor element 12. This can prevent an increase in the size of the semiconductor element 12 caused by the provision of the heat dissipating path 18.

Additionally, because the heat dissipating path 18 can achieve anchoring effects, the strength of bonding the heat sink 14 to the semiconductor element 12 can be enhanced, and furthermore, the reliability of bonding the electronic component module 2 to the mother board 10 can be improved.

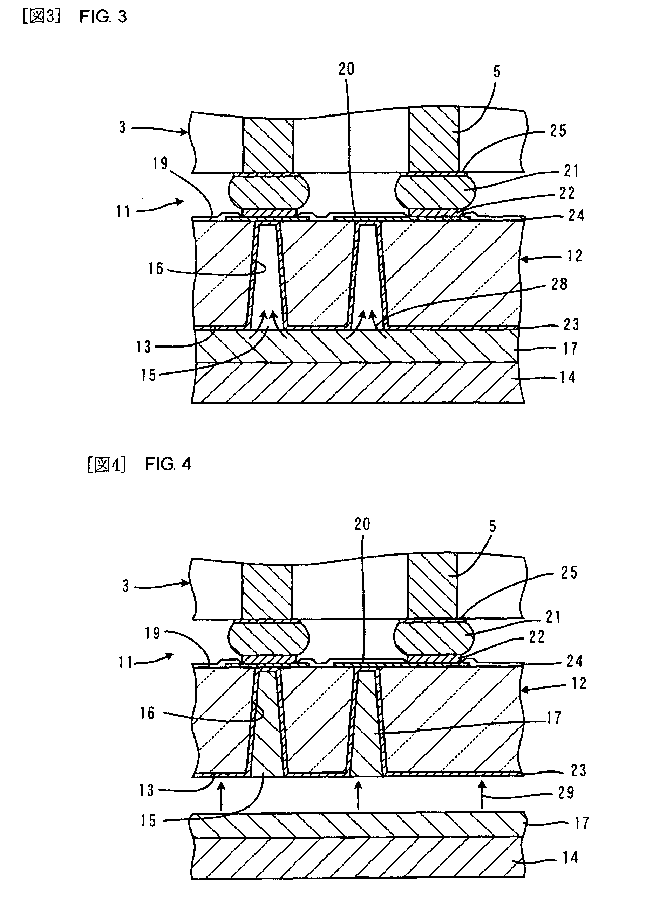

A method for manufacturing the electronic component module 2 is described next with reference to Fig. 3.

First, the wiring board 3, the surface-mountable component 7, and the metallic cover 8 illustrated in Fig. 1 are prepared, and the semiconductor element 12 is prepared.

Here, for the semiconductor element 12, for example, a titanium film having a thickness of 0.2 µm and a nickel film having a thickness of 5.0 µm formed thereon are provided on each of the conductive films 20 formed on the second principal surface 19 to form the under-bump metal 22. Additionally, the conductive bump 21 made of, for example, Sn3.5Ag solder is formed on the under-bump metal 22, and the protective film 24 made of, for example, silicon dioxide is formed.

At the first principal surface 13 side of the semiconductor element 12, after it is ground so as to have a predetermined thickness, the non-through holes 16 are formed by etching. Each of the holes 16 is typically a hole having a circular cross-sectional shape and a dimension in the diameter direction of approximately 60 µm. However, the size and the cross-sectional shape of the hole 16 are not particularly limited. For example, the cross-sectional shape may be a square, a rectangle, or a triangle.

Then, the metallic film 23 is formed on the inner surface of the non-through hole 16 and on the first principal surface 13. To form the metallic film 23, for example, a titanium film having a thickness 0.05 µm and then a gold film having a thickness of 0.1 µm are formed employing a thin-film process, and after that, a gold film having a thickness of 3.0 µm is formed employing electroplating.

To form the heat dissipating path 18, solder for use as the conductive material 17 to be filled in the non-through hole 16 is prepared, and the heat sink 14 to be arranged along the first principal surface 13 of the semiconductor element 12 is prepared. More specifically, a metal plate made of a Ni-Co-Fe alloy is prepared, and after the metal plate is rolled, nickel plating and gold plating are applied thereon as surface treatment. Then, solder sheet is melt-bonded to the metal plate by being melted while being overlaid on one side of the metal plate.

Here, Au20Sn solder can be used as the solder, for example. Because the melting point of this solder is higher than that of the solder 27 for use in implementing the electronic component module 2 on the mother board 10, this solder is not remelted in implementing on the mother board 10, so the bonding reliability between the semiconductor element 12 and the heat sink 14 is not degraded. The above-described melting bonding is typically carried out in a reducing atmosphere using a reflow oven whose peak temperature is set at the neighborhood of 320°C.

Then, the metal plate with the solder sheet being bonded is die-cut into desired dimensions, and thus the heat sink 14 is obtained. Fig. 3 illustrates the heat sink 14 bonded to the solder sheet for use as the conductive material 17.

Alternatively, after the heat sink 14 is obtained by the die-cutting of the metal plate into desired dimensions, the solder sheet may be melt-bonded thereto. In place of the solder sheet, solder paste may be applied to the metal plate or the heat sink 14.

Then, flux is applied onto the conductive bump 21 of the semiconductor element 12 by, for example, transferring. The semiconductor element 12 is aligned such that the conductive bump 21 is positioned onto the conductive film 25 inside the cavity 11 of the wiring board 3. In this state, the conductive bump 21 is melt-bonded to the conductive film 20 by reflowing. After that, a residue of the flux is removed by cleaning.

Then, although not shown in the drawing, the underfill resin is injected between the semiconductor element 12 and the cavity 11, and after that, it is cured.

Then, as illustrated in Fig. 3, the heat sink 14 is arranged along the first principal surface 13 of the semiconductor element 12 in the state in which the solder sheet used as the conductive material 17 faces the first principal surface 13 of the semiconductor element 12. In the state in which the solder used as the conductive material 17 lies between the first principal surface 13 of the semiconductor element 12 and the heat sink 14, the molten solder is introduced into the non-through hole 16, as indicated by the arrow 28. At this time, in addition to capillary action caused by the non-through hole 16, a wet-up phenomenon of the metallic film 23 acts. Therefore, the solder used as the conductive material 17 can be introduced into the hole 16 quickly with high filling capabilities. This process can be carried out using, for example, a reflow oven. The atmosphere in the reflow oven may preferably be a reducing atmosphere. The temperature is selected at which the solder used as the conductive material 17 is sufficiently melted. Typically, a temperature higher than the melting point of the solder by 30°C to 50°C can be selected as the temperature in the reflow oven, and in the case of Au20Sn solder, approximately 320°C may preferably be selected.

As described above, when the solder used as the conductive material 17 introduced into the non-through hole 16 is solidified, the heat dissipating path 18 being in the state in which the non-through hole 16 is filled with the solder is formed, and the state in which the heat sink 14 is bonded to the semiconductor element 12 with the solder used as the conductive material 17 disposed therebetween is established.

Then, as illustrated in Fig. 1, the surface-mountable component 7 is implemented on the upper surface of the wiring board 3. After that, the metallic cover 8 is attached to the wiring board 3, and the electronic component module 2 is completed.

Fig. 4 is an illustration that describes another method for manufacturing the electronic component module 2, in particular, the semiconductor device 1 and corresponds to Fig. 3. In Fig. 4, the same reference numerals are used in elements corresponding to those illustrated in Fig. 2 or 3, and the redundant description is omitted.

A feature of the manufacturing method illustrated in Fig. 4 is a method for forming the heat dissipating path 18. That is, the conductive material 17 positioned inside the non-through hole 16 and the conductive material 17 positioned between the semiconductor element 12 and the heat sink 14 are applied in different processes. In other words, at a stage prior to bonding the heat sink 14 to the semiconductor element 12, the non-through hole 16 of the semiconductor element 12 is filled with the conductive material 17. After that, as indicated by the arrow 29, the heat sink 14 is bonded to the first principal surface 13 of the semiconductor element 12 with the remaining conductive material 17 disposed therebetween.

As described above, fluid molten solder, metallic paste, or conductive adhesive can be favorably used as the conductive material 17 for use in being filled in the non-through hole 16. The non-through hole 16 may be filled with conductive material 17 by growing metal plating or laminating metallic films using a thin-film process. Alternatively, a small piece made of a conductive material differently prepared may be inserted into the non-through hole 16. In bonding the heat sink 14 to the semiconductor element 12 using the remaining conductive material 17, solder, metallic paste, or conductive adhesive can be used as the conductive material 17.

The embodiment according to the present invention has been described above with reference to the drawings.
Various other variations can also be made.

For example, the non-through hole 16 provided to the semiconductor element 12, the bottom of the non-through hole 16 being defined by the conductive film 20 in the illustrated embodiment, may also be formed such that the bottom is positioned in an intermediate portion of the semiconductor element 12 in its thickness direction.

The solder used as the conductive material 17 in the manufacturing method described with reference to Fig. 3 may be replaced by fluid metallic paste or conductive adhesive.

In addition to or in place of the surface-mountable component 7 implemented on the upper surface of the wiring board 3 as illustrated in Fig. 1, a different semiconductor element may be mounted by flip-chip mounting or wire bonding, for example. Alternatively, no component, such as the surface-mountable component 7, may be mounted on the upper surface of the wiring board 3.

In the electronic component module 2 illustrated in Fig. 1, the metallic cover 8 may be replaced by resin coating.

A cavity other than the illustrated cavity 11 may further be provided to the wiring board 3.

## Claims

1. A semiconductor device comprising:
a semiconductor element; and
a metallic heat sink arranged along a first principal surface of the semiconductor element,
wherein the semiconductor element is provided with a heat dissipating path, the heat dissipating path being defined by a non-through hole opened to the first principal surface and formed by filling the non-through hole with a conductive material, and
the heat sink is bonded to the semiconductor element with the conductive material disposed therebetween.

2. The semiconductor device according to Claim 1, wherein the conductive material comprises solder.

3. The semiconductor device according to Claim 1, further comprising a conductive film disposed on a second principal surface of the semiconductor element, the second principal surface being opposite to the first principal surface,
wherein a bottom of the non-through hole is defined by the conductive film.

4. An electronic component module comprising:
the semiconductor device according to any one of Claims 1 to 3; and
a wiring board having a cavity,
wherein the semiconductor device is received in the cavity such that the heat sink faces outward.

5. A method for manufacturing a semiconductor device, the method comprising:
preparing a semiconductor element including a non-through hole opened to a first principal surface;
preparing solder for use as a conductive material to be filled in the non-through hole to form a heat dissipating path;
preparing a metallic heat sink to be arranged along the first principal surface of the semiconductor element; and
arranging the heat sink along the first principal surface of the semiconductor element, introducing the solder being molten into the non-through hole while having the solder disposed between the first principal surface of the semiconductor element and the heat sink, and thus forming the heat dissipating path in which the non-through hole is filled with the solder and establishing a state in which the heat sink is bonded to the semiconductor element with the solder disposed therebetween.

6. The method for manufacturing a semiconductor device according to Claim 5, further comprising, before introducing the solder being molten into the non-through hole, forming a metallic film on an inner surface of the non-through hole and on the first principal surface.
